(19)

Europäisches Patentamt
European Patent Office
Office européen des brevets

(11) **EP 4 741 929 A1**

(12) **EUROPEAN PATENT APPLICATION**
published in accordance with Art. 153(4) EPC

(43) Date of publication:
**13.05.2026 Bulletin 2026/20**

(21) Application number: **24855793.6**

(22) Date of filing: **20.08.2024**

(51) International Patent Classification (IPC):
*G03F 7/42* (2006.01)

(52) Cooperative Patent Classification (CPC):
G03F 7/42

(86) International application number:
**PCT/CN2024/113270**

(87) International publication number:
**WO 2025/040070 (27.02.2025 Gazette 2025/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **23.08.2023 CN 202311068981**

(71) Applicant: **Beijing NAURA Microelectronics
Equipment Co., Ltd.
Beijing 100176 (CN)**

(72) Inventors:
• **LI, Meng
Beijing 100176 (CN)**
• **KONG, Yuwei
Beijing 100176 (CN)**
• **LIN, Yuanwei
Beijing 100176 (CN)**

(74) Representative: **Cohausz & Florack
Patent- & Rechtsanwälte
Partnerschaftsgesellschaft mbB
Bleichstraße 14
40211 Düsseldorf (DE)**

(54) **METHOD FOR REMOVING PHOTORESIST ON WAFER, AND SEMICONDUCTOR PROCESS DEVICE**

(57) The present disclosure provides a method of removing photoresist on a wafer and a semiconductor process device. During the process of removing the photoresist after ion implantation, a spectral intensity of an emitted light generated by a particular element in a chamber corresponding to different sampling moments is obtained; based on spectral intensities corresponding to two adjacent sampling moments, variation characteristic of spectral intensity at each sampling moment is determined; when the variation characteristic corresponding to a current sampling moment satisfies a preset condition, it is determined that the hardened layer removal process is near an end point and the wafer is controlled to descend from its current position toward a heating base according to a preset relationship to remove a hardened layer of the photoresist. By obtaining the spectral intensity of the emitted light produced by a particular element, and judging whether the hardened layer removal process is near the end point based on whether the variation characteristic of the spectral intensity satisfies the preset condition, the wafer is controlled to descend and the temperature is increased only when the hardened layer removal process is near its end point to avoid the hardened layer from popping at high temperature.

FIG. 5

**Description**

FIELD OF THE TECHNOLOGY

The present disclosure relates to a field of semiconductor manufacturing, and in particular, to a method for removing photoresist on a wafer and semiconductor process device.

BACKGROUND

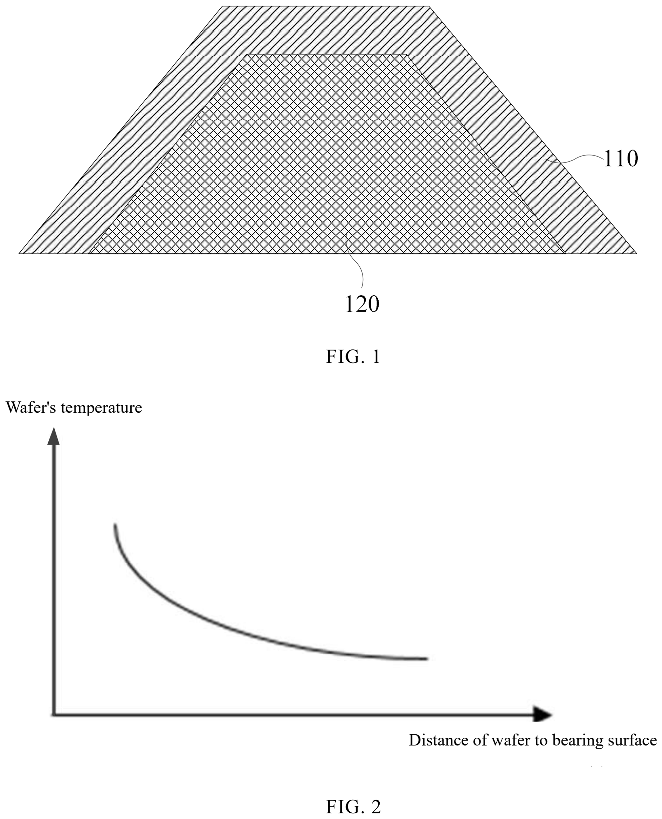

During semiconductor processing, extremely fine patterns need to be fabricated on wafers. Typically, photolithography is used to transfer a circuit pattern on a mask onto a photoresist coating the wafer surface. Etching is then used to transfer the photoresist pattern onto the wafer. To prevent the wafer from being affected by the photoresist during subsequent processing, residual photoresist on the wafer must be removed. In conventional dry resist removal processes, wafers are typically placed directly at relatively high temperatures for resist removal. However, ion implantation of photoresist carbonizes the surface of the photoresist, causing it to form a hardened layer 110 (as shown in FIG. 1) and an un-crosslinked layer (photoresist, PR) 120. The hardened layer 110 is coated on the outside of the un-crosslinked layer 120, and the hardened layer 110 is susceptible to popping at high temperatures.

SUMMARY

The present disclosure aims to solve at least one of the technical problems in certain existing technologies, and proposes a method for removing photoresist on a wafer and a semiconductor process device.
To achieve the objectives of the present disclosure, a method for removing photoresist from a wafer is provided, including:

during the process of removing photoresist after ion implantation, obtaining the spectral intensity of emitted light generated by a particular element in a chamber at different sampling moments;
determining, based on the spectral intensities corresponding to two adjacent sampling moments, a variation characteristic of the spectral intensity at each sampling moment;
when the variation characteristic corresponding to the current sampling moment satisfies a preset condition, determining that the hardened layer removal process is near its end point and controlling the wafer to descend from its current position toward a heating base according to a preset relationship to remove the hardened layer of the photoresist.

In certain embodiments, the variation characteristic is the rate of decrease of the spectral intensity between two adjacent sampling moments, and the variation characteristic satisfies the following formula:

$$Q_n = [S(t_{n-1}) - S(t_n)] \div S(t_{n-1});$$

where, $Q_n$ is the variation characteristic corresponding to the nth sampling moment, $S(t_n)$ is the spectral intensity corresponding to the nth sampling moment, and n is a positive integer.
In certain embodiments, the preset condition includes the variation characteristic corresponding to the current sampling moment being greater than a preset value, where the preset value is a non-negative number.
In certain embodiments, the preset value is greater than or equal to 5% and less than or equal to 20%.
In certain embodiments, the preset condition also includes a delay duration between the time when the spectral intensity reaches its maximum value and the current sampling moment.
In certain embodiments, the delay duration is calculated according to the following formula:

$$T = k/Q_{max};$$

where, T is the delay duration; k>0, and k is a constant; $Q_{max}$ is the maximum value of the absolute value of the variation characteristic before the spectral intensity reaches the maximum value.
In certain embodiments, the preset relationship is that the descent displacement $\Delta h$ of the wafer is equal to the product of the descent duration $\Delta t$ and a constant a, and a is greater than 0.
In certain embodiments, before obtaining the spectral intensity of the emitted light generated by the particular element in the chamber at different sampling moments, the removal method further includes:
placing the wafer on the bearing surface of the heating base and, after the preheating duration has elapsed, controlling the wafer to ascend to an initial high position.

In certain embodiments, after controlling the wafer to descend from its current position toward the heating base in a predetermined relationship to remove the hardened layer of the photoresist, the method further includes:
when the variation characteristic corresponding to the current sampling moment satisfies the hardened layer removal termination condition, controlling the wafer to descend to the bearing surface of the heating base to remove the un-crosslinked layer of the photoresist.

As another technical solution, the present disclosure also provides a semiconductor process device, including: a chamber, a heating base and a controller, the heating base is arranged in the chamber, and has a bearing surface for supporting a wafer; the controller includes at least one processor and at least one memory, the memory stores a computer program, and the processor executes the computer program to execute the removal method described in the present disclosure.

The present disclosure has the following beneficial effects:

The method of removing photoresist on a wafer and the semiconductor process device provided in the present disclosure obtains the spectral intensity of the emitted light generated by a particular element, and judges whether the hardened layer removal process is near an end point based on whether the variation characteristic of the spectral intensity satisfies the preset condition. When the hardened layer removal process is near the end point, the wafer is controlled to descend and the temperature is increased to avoid the hardened layer from popping at high temperature.

Moreover, by applying the removal method of the present disclosure, the wafer descends before the hardened layer removal process reaches the end point. In this way, while ensuring that the hardened layer will not burst, on the one hand, the rate of removing the residual hardened layer is improved, so that the small amount of remaining hardened layer is quickly removed during the wafer descending process, and the hardened layer removal process may reach the end point in advance, shortening the time to remove the hardened layer, thereby improving the degumming efficiency. On the other hand, during the time duration from the moment the hardened layer removal process nears the end point to the moment it reaches the end point, the distance between the wafer and the bearing surface gradually decreases, and the temperature of the wafer increases, so that after the hardened layer removal process reaches the end point, the wafer may be quickly heated up to the process temperature corresponding to the un-crosslinked layer removal process. That is to say, the wafer may be heated up in advance during the above time duration before switching to the un-crosslinked layer removal process, so that the wafer may quickly reach the process temperature required for the un-crosslinked layer removal process, and the time required for the temperature of the wafer to rise to remove the un-crosslinked layer when the hardened layer removal process reaches the end point is shortened as much as possible, thereby improving the degumming efficiency.

BRIEF DESCRIPTION OF THE DRAWINGS

FIG. 1 is a schematic diagram of photoresist after ion implantation;
FIG. 2 is a schematic diagram showing the relationship between wafer temperature and the distance between the wafer and the bearing surface;
FIG. 3 is a schematic diagram showing the structure of a semiconductor process device provided in certain embodiments of the present disclosure;
FIG. 4 is a schematic diagram showing the hardware modules of a semiconductor process device provided in certain embodiments of the present disclosure;
FIG. 5 is a schematic flow chart of a method of removing photoresist from a wafer according to certain embodiments of the present disclosure;
FIG. 6 is a schematic diagram illustrating the relationship between wafer temperature and photoresist removal rate;
FIG. 7 is a schematic diagram showing the relationship between spectral intensity and sampling moment during the photoresist removal process, where the wafer is controlled to descend when the hardened layer removal process reaches its end point;
FIG. 8 is a schematic diagram showing the relationship between the height of the wafer relative to the bearing surface and sampling moment during the photoresist removal process corresponding to FIG. 7;
FIG. 9 is a schematic diagram showing the relationship between spectral intensity and sampling duration during a resist removal process using a method provided in certain embodiments of the present disclosure;
FIG. 10 is a schematic diagram showing the relationship between the height of the wafer relative to the bearing surface and sampling duration during the resist removal process corresponding to FIG. 9;
FIG. 11 is a graph showing the relationship between spectral intensity and sampling duration during a resist removal process using another method provided in certain embodiments of the present disclosure;

FIG. 12 is a schematic diagram showing the relationship between the height of the wafer relative to the bearing surface and sampling duration during the resist removal process corresponding to FIG. 11;

FIG. 13 is a schematic diagram showing a flow chart of another method of removing photoresist on a wafer provided in certain embodiments of the present disclosure.

DETAILED DESCRIPTION

Before introducing certain embodiments of the present disclosure, the related technologies are first described.

Because hardened layer 110 may pop at high temperatures, the following steps may be used to prevent popping during post-ion implantation resist removal. Step 1: Removal of hardened layer 110: The wafer temperature is adjusted to a low value, and a mixture of $O_2$ and $N_2$ and $H_2$ is injected. $O_2$ removes elements such as C, H, N, and S from hardened layer 110. The $N_2$ and $H_2$ mixture causes non-volatile substances (oxides such as $P_2O_5$ and $As_2O_3$) to react with H to form volatile products. Step 2: Removal of the un-crosslinked layer 120: The temperature of the wafer is adjusted to a higher temperature value, and $O_2$ is injected. $O_2$ reacts with the un-crosslinked layer 120 to form volatile products.

When using semiconductor process device to remove resist from wafers, the wafer may be placed on the bearing surface of a heating base. The heating base bears the wafer, and the wafer may be moved relative to the heating base to a position a certain distance from the bearing surface. The heating base is equipped with a heater, which is powered to heat the heating base, which is then transferred to the wafer to regulate its temperature. The temperature of the wafer is related to the distance between the wafer and the bearing surface. The relationship between the two is shown in FIG. 2. Specifically, along a vertical direction, the smaller the distance between the wafer and the bearing surface is, the higher the temperature of the wafer is; along the vertical direction, the larger the distance between the wafer and the bearing surface is, the lower the temperature of the wafer is.

Based on this, it is advisable to reasonably adjust the distance between the wafer and the bearing surface to control the semiconductor process device to first perform the hardened layer removal process step, and then perform the un-crosslinked layer removal process step after the hardened layer is removed.

In related technologies, the distance between the wafer and the bearing surface and the process duration during the hardened layer removal process are set to empirical values, as are the distance between the wafer and the bearing surface and the process duration during the un-crosslinked layer removal process. This creates a specific process recipe. When using the same process recipe for resist removal, the wafer lift process remains the same.

However, the inventors of the present disclosure found that due to the different ion implantation amounts of different types of wafers, the thickness of the hardened layer of different types of wafers is different. Therefore, when using a specific process formula to remove the resist of different types of wafers, the following problems are likely to occur: First, before the process time of the hardened layer removal process step reaches the set empirical value, the hardened layer has been completely removed, and the distance between the wafer and the bearing surface is still large, and the switch from step 1 to step 2 is not made in time, resulting in a long resist removal process, low efficiency, and low production capacity. Second, when the hardened layer removal process reaches the set empirical value, the hardened layer is not completely removed, the distance between the wafer and the bearing surface decreases prematurely, and the process switches from step 1 to step 2 too early, causing the hardened layer to pop at a higher temperature. Therefore, using a specific process recipe for resist removal is not suitable for different wafer types.

The essence of these problems is that because the thickness of the hardened layer of different types of wafers is different, when a specific process formula is used for resist removal, and when the process time of the hardened layer removal process reaches the set empirical value, the end point of the hardened layer removal process is reached by default. This may easily lead to inaccurate judgment of the end point of the hardened layer removal process and may not be adapted to different types of wafers.

In order to solve the above-mentioned problems existing in the related technologies, the inventors of the present disclosure propose a method for removing photoresist on a wafer. The method judges whether the hardened layer removal process has reached the end point based on the spectral intensity of the emitted light generated by a particular element in the chamber. When the hardened layer removal process reaches the end point, the wafer is controlled to descend onto a heating base, so that the wafer is heated to remove the un-crosslinked layer. In this way, the end point of the hardened layer removal process is determined based on changes in the spectral intensity signal, achieving automatic detection of the hardened layer removal process end point. Furthermore, during the hardened layer removal process, the spectral intensity of a particular element changes with the amount of process gas or reactive gas containing that element. Therefore, even if the thickness of the hardened layer formed on wafers manufactured using the same process varies, this method may accurately monitor the progress of the photoresist removal process and determine the end point of the hardened layer removal process with high accuracy.

However, in practical implementation, the wafer is heated up due to the thermal radiation from the heating base, and the wafer heating process takes a certain amount of time. Therefore, the wafer is controlled to descend only when the hardened layer removal process reaches the end point. The wafer may not be quickly heated to the higher temperature value required to remove the un-crosslinked layer, resulting in low removal efficiency of the hardened layer and the un-crosslinked layer.

In order to improve the resist removal efficiency, certain embodiments of the present disclosure further provide a method for removing photoresist on a wafer and a semiconductor process device.

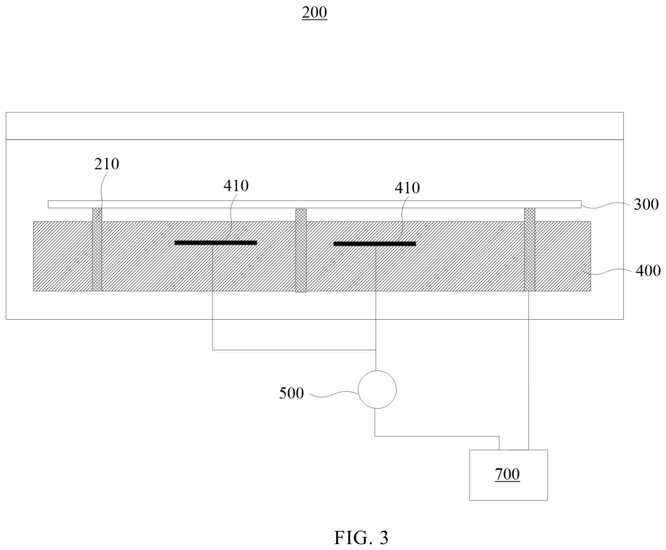

FIG. 3 is a schematic diagram of the structure of a semiconductor process device provided in certain embodiments of the present disclosure. Referring to FIG. 3, the semiconductor process device includes a chamber 200 and a heating base 400. The heating base 400 is located within the chamber 200 and has a bearing surface for bearing a wafer 300. The chamber 200 and the heating base 400 enable a resist removal process to remove ordinary photoresist or ion-implanted photoresist from the surface of the wafer 300.

A heater 410 is provided inside the heating base 400, and the heater 410 is connected to a power supply 500 arranged outside of the chamber 200. The heater 410 is powered on to heat the heating base 400, so that the heating base 400 is heated and the heat of the heating base 400 is transferred to the wafer 300 to adjust the temperature of the wafer 300.

In certain embodiments, the semiconductor process device also includes a lift assembly (not shown in the figure) and three lift pins 210. The heating base 400 is provided with three through holes corresponding to the three lift pins 210. The three lift pins 210 press against the back of the wafer 300. The lift assembly is used to drive the three lift pins 210 to ascend and descend along the corresponding through holes, so that the distance between the wafer 300 and the bearing surface of the heating base 400 changes, so as to change the heat radiated from the heating base 400 to the wafer 300, thereby achieving temperature regulation of the wafer 300. The number of the lift pins 210 is not limited to three, and may be designed based on experience and working conditions.

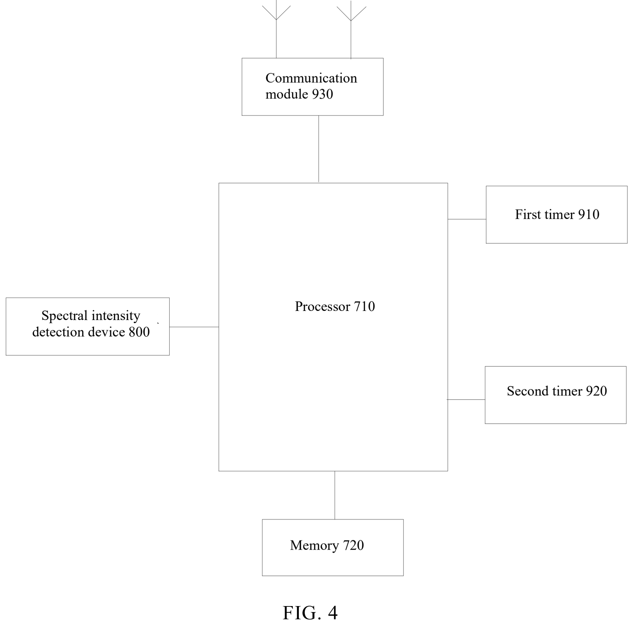

FIG. 4 is a schematic diagram of a hardware module of a semiconductor process device provided by certain embodiments of the present disclosure. Referring to FIG. 3 and FIG. 4, the semiconductor process device further includes a spectral intensity detection device 800 and a controller 700.

Exemplarily, the controller 700 includes at least one processor 710 and at least one memory 720. The memory 720 may be used to store program code. The memory 720 may be configured as any type of memory. For example, the memory 720 may be implemented as flash memory, read-only memory (ROM), random access memory (RAM), removable memory, other types of storage elements, or any combination of such storage devices.

The processor 710 may be used to execute the above-mentioned application code and call related modules to implement the functions of the semiconductor process device in certain embodiments of the present disclosure. The processor 710 may include one or more processing units, for example: the processor 710 may include an application processor (AP), a modem processor, a graphics processor (GPU), an image signal processor (ISP), a video codec, a digital signal processor (DSP), a baseband processor, and/or a neural-network processing unit (NPU). Among them, different processing units may be independent devices or integrated into one or more processors 710.

The spectral intensity detection device 800 is used to detect the spectral intensity of the emitted light generated by a particular element. The spectral intensity detection device 800 is electrically connected to the controller 700 to transmit the detected spectral intensity to the controller 700. Specifically, the spectral intensity detection device 800 may be implemented using a spectral sensor. The spectral intensity detection device 800 may detect the spectral intensity in real time or collect spectral intensity at preset intervals.

In certain embodiments, the semiconductor process device disclosed herein may further include a first timer 910 and a second timer 920, both of which are connected to the controller 700 and are used for timing.

The controller 700 is also connected to the lift assembly via a communication module 930 to control the lift assembly to drive the three lift pins 210 to ascend and descend along the corresponding through holes, thereby changing the distance between the wafer 300 and the bearing surface of the heating base 400. The communication module 930 may be implemented as one or more suitable communication interfaces.

The structures illustrated in certain embodiments of the present disclosure do not constitute restrictions on semiconductor process device. In certain embodiments of the present disclosure, the semiconductor process device may include more or fewer components than shown, or may combine or separate certain components, or arrange the components differently. The illustrated components may be implemented in hardware, software, or a combination of software and hardware.

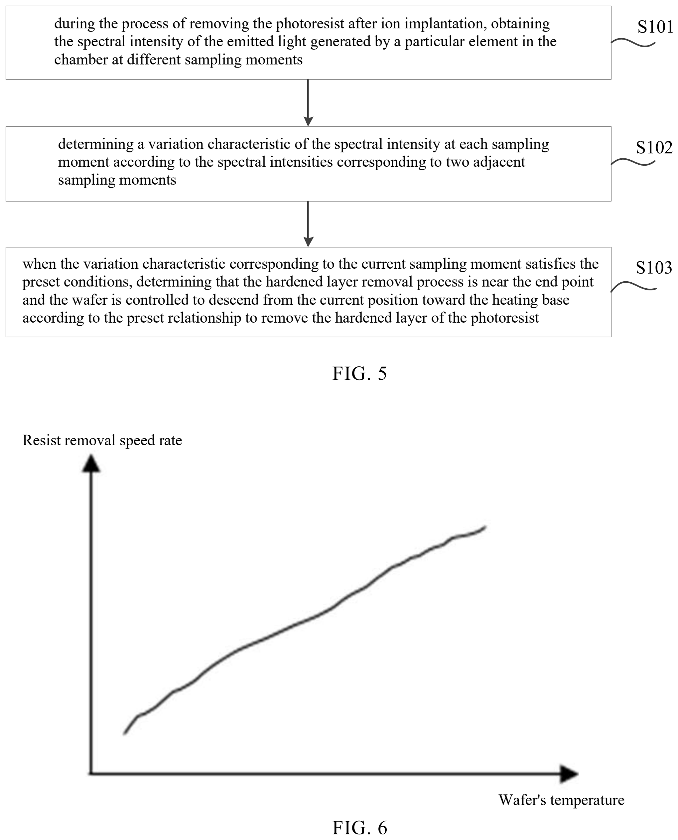

FIG. 5 is a flow chart of a method for removing photoresist on a wafer provided in certain embodiments of the present disclosure. For the above-mentioned semiconductor process device, the method for removing photoresist on a wafer may be executed. The process of the removal method may be seen in FIG. 5, including:

S101, during the process of removing the photoresist after ion implantation, obtaining the spectral intensity of the emitted light generated by a particular element in the chamber at different sampling moments.

The particular element may be the element implanted by the ions, such as P, As, B, or the like.

This step may be achieved by receiving the spectral intensity detected by the spectral intensity detection device 800, thereby acquiring the spectral intensity.

There is a one-to-one correspondence between each sampling moment and the spectral intensity at that sampling moment. Similarly, the time from each sampling moment to the first sampling moment is the sampling duration, and there is also a one-to-one correspondence between the sampling duration and the spectral intensity corresponding to the sampling duration.

S102, determining a variation characteristic of the spectral intensity at each sampling moment according to the spectral intensities corresponding to two adjacent sampling moments.

S103, when the variation characteristic corresponding to the current sampling moment satisfies the preset conditions, determining that the hardened layer removal process is near the end point and the wafer is controlled to descend from the current position toward the heating base according to the preset relationship to remove the hardened layer of the photoresist.

The preset conditions should be properly designed so that the variation characteristic corresponding to the current sampling moment satisfies the preset conditions before satisfying the hardened layer removal termination conditions. The fact that the variation characteristic corresponding to the current sampling moment satisfies the preset conditions should indicate that most of the hardened layer has been removed, but that a small amount of hardened layer remains, indicating that the hardened layer removal process is near its end point.

The variation characteristic in spectral intensity should reflect the progress of the resist removal process, allowing more accurate judgment of the end point of the hardened layer removal process based on the variation characteristic. Therefore, the particular element should also exhibit different spectral intensity variation trends during hardened layer removal and during un-crosslinked layer removal.

Combined with the above description, it may be seen that when the process of removing the hardened layer begins, the wafer should be at the initial high position. At this time, the distance between the wafer and the bearing surface is H1, so that the temperature of the wafer is lower than or equal to 200°C to avoid popping. The general process of applying the removal method of certain embodiments is as follows: if the variation characteristic corresponding to the current sampling moment satisfies the preset conditions, the wafer is controlled to descend from the initial high position to approach the heating base, so that the wafer temperature is increased and the small amount of residual hardened layer is removed. During the descent process, the spectral intensity of the emitted light generated by the particular element continues to be obtained. If the variation characteristic corresponding to the current sampling moment still satisfies the preset conditions, the wafer is controlled to descend from the current position and the small amount of remaining hardened layer continues to be cleaned until the hardened layer is completely removed.

As disclosed herein, the wafer may be controlled to descend from its current position toward the heating base in the removal method by, for example, sending a signal to a lift assembly to cause the lift assembly to drive the lift pins downward, thereby driving the wafer downward.

The removal method of certain embodiments obtains the spectral intensity of the emitted light generated by a particular element, and determines whether the hardened layer removal process is approaching the end point based on whether the variation characteristic in the spectral intensity satisfies the preset conditions. When the hardened layer removal process is approaching the end point, the wafer is controlled to descend and heat up. In other words, the distance between the wafer and the heating base is large before the wafer descends, keeping the wafer temperature relatively low to prevent the hardened layer from popping at high temperatures. It's worth noting that near the end of the hardened layer removal process, only a small amount of hardened layer remains. Even if the wafer heats up as it descends, this remaining hardened layer won't pop. Therefore, the removal method of certain embodiments may effectively solve the problem of the hardened layer popping at high temperatures.

It may be understood that during the resist removal process, when the wafer temperature is the only variable in the process conditions, the resist removal rate is positively correlated with the wafer temperature. For details, please refer to FIG. 6, that is, the higher the wafer temperature, the faster the resist removal rate. Based on this, in the removal method of certain embodiments, the wafer is lowered before the hardened layer removal process reaches the end point. In this way, when the removal method of certain embodiments is used to remove the resist, since part of the hardened layer has been removed, its thickness becomes thinner. By controlling the wafer to descend according to a preset relationship, "popping" may be avoided. On the one hand, the temperature of the wafer may be increased so that the remaining hardened layer may be removed at a higher temperature, thereby increasing the removal rate of the hardened layer and allowing the small amount of remaining hardened layer to be quickly removed during the wafer descent process. The hardened layer removal process may then reach its end point ahead of time, shortening the time to remove the hardened layer and thereby improving the degumming efficiency. On the other hand, during the time duration from when the hardened layer removal process approaches the end point to when it reaches the end point, the distance between the wafer and the bearing surface gradually decreases, and the temperature of the wafer increases, so that after the hardened layer removal process reaches the end point, the wafer may be quickly heated to the process temperature corresponding to the un-crosslinked layer removal process. That is to say, the wafer may be heated up in advance within the above-mentioned time duration before switching to the un-crosslinked layer removal process, so that the wafer may quickly reach the process temperature required for the un-crosslinked layer removal process, and shorten the heating time required to switch from the hardened layer removal process to the un-crosslinked layer removal process as much as possible, thereby improving the resist removal efficiency.

The removal method disclosed herein may further perform S104 after S103.

At S104, when the variation characteristic corresponding to the current sampling moment satisfies the hardened layer removal termination condition, the wafer is controlled to descend to the bearing surface of the heating base to remove the un-crosslinked layer of the photoresist.

Among them, the variation characteristic corresponding to the current sampling moment satisfies the hardened layer removal termination condition, which means that the hardened layer is completely removed and the hardened layer removal process reaches the end point.

The general process of applying the removal method of certain embodiments is as follows: when the variation characteristic corresponding to the current sampling moment satisfies the preset conditions, the wafer is controlled to descend from the current position to continue removing the small amount of remaining hardened layer. Then, the spectral intensity of the emitted light generated by the particular element is continued to be obtained. If the variation characteristic corresponding to the current sampling moment satisfies the termination condition for removal of the hardened layer, the wafer is controlled to continue to descend to the bearing surface of the heating base, and the temperature of the wafer is increased to 250°C to 300°C to remove the un-crosslinked layer.

It should be noted that the above-mentioned variation characteristic may be understood in a broad sense, as long as it may characterize the variation trend of the photoresist removal process.

In a first implementation, the variation characteristic may be the variation in the spectral intensity of the emitted light generated by a particular element between two adjacent sampling moments. The variation characteristic may be determined according to the following formula (1), where $S(t_n)$ is the spectral intensity corresponding to the nth sampling moment, n is a positive integer, $S(t_{n-1})$ is the spectral intensity corresponding to the n-1th sampling moment, and $\Delta S_n$ is the variation characteristic corresponding to the nth sampling moment.

$$\Delta S_n = S(t_n) - S(t_{n-1}) \qquad \text{Formula (1)}$$

In a second implementation, the variation characteristic may be the rate of change of the spectral intensity of the emitted light generated by a particular element between two adjacent sampling moments. The variation characteristic may be determined according to the following formula (2), where $S_n'$ is the variation characteristic at the nth sampling moment, and $t_n - t_{n-1}$ is the sampling duration between the nth sampling moment and the (n-1)th sampling moment.

$$S_n' = [S(t_n) - S(t_{n-1})] / (t_n - t_{n-1}) \qquad \text{Formula (2)}$$

In a third implementation, the variation characteristic may be the rate of decrease of the spectral intensity between two adjacent sampling moments. The variation characteristic may be determined according to the following formula (3), where $Q_n$ is the variation characteristic corresponding to the nth sampling moment.

$$Q_n = [S(t_{n-1}) - S(t_n)] \div S(t_{n-1}) \qquad \text{Formula (3)}$$

As the hardened layer removal process nears completion, the spectral intensity continues to decline. Therefore, using the rate of decrease to characterize the variation characteristic makes it easier to determine whether the variation characteristic satisfies the preset conditions. The following explanation uses the variation characteristic $Q_n$ as an example. Those skilled in the technical field readily understand the technical solution using the variation characteristic $\Delta S_n$ or $S_n'$ after reading the following text.

As described herein, the termination condition for hardened layer removal may be that the variation characteristic is 0 or close to 0, indicating that the spectral intensity of the particular element has not changed, which means that the gas amount of process gas or reaction gas containing the particular element tends to be stable, and the hardened layer removal process reaches the end point.

In the removal method disclosed herein, the preset condition may include that the variation characteristic corresponding to the current sampling moment is greater than a preset value, and the preset value is a non-negative number. In other words, the preset condition satisfies the variation characteristic Qn>0. Combined with the above, it may be seen that if the variation characteristic corresponding to the current sampling moment is a positive number, that is, the spectral intensity decrease rate of the emitted light generated by a particular element is greater than 0, it means that the spectral intensity is on the falling edge, which indicates that the hardened layer removal process is approaching the end point. At this time, the wafer may be controlled to descend to remove the remaining hardened layer.

The preset value may be greater than or equal to 5% and less than or equal to 20%. Taking the preset value of 5% as an example, when the rate of decrease (for example, the variation characteristic) of the spectral intensity between two adjacent sampling moments is greater than 5%, the wafer is controlled to descend. Here, the preset value is an empirical value obtained through a large number of process tests and simulation experiments. At this time, the method of certain embodiments is used to remove the photoresist after ion implantation, and the removal efficiency is high. Of course, the preset value is not limited to 5% to 20%, and may be designed according to actual working conditions.

A comparison is made between a resist removal process in which the wafer is controlled to descend when the hardened layer removal process reaches an end point and a resist removal process using the removal method of certain embodiments.

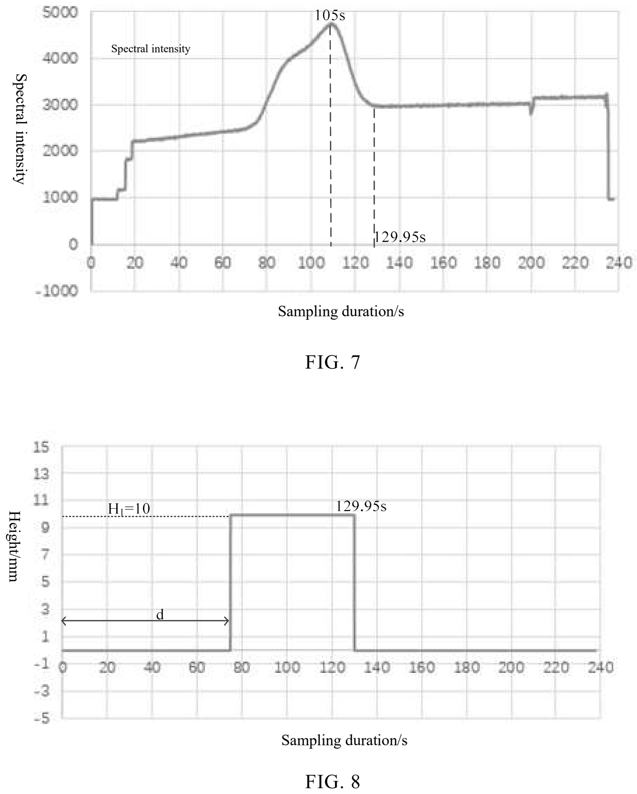

FIG. 7 is a curve relationship diagram of the spectral intensity and sampling duration during the resist removal process that controls the wafer to descend when the hardened layer removal process reaches the end point. FIG. 8 is a curve relationship diagram of the height of the wafer relative to the bearing surface and the sampling duration during the resist removal process corresponding to FIG. 7. In the examples shown in FIGs. 7 and 8, the resist removal process is as follows: first, the wafer is controlled to ascend to the initial high position, and the height of the wafer relative to the bearing surface is H1, so as to remove the hardened layer; the height of the wafer relative to the bearing surface is controlled to remain at H1; when the sampling duration is 105s, it is detected that the spectral intensity reaches the maximum value; until the sampling duration is 129.95s, it is determined that the variation characteristic Qn of the spectral intensity at the current sampling duration is 0%, which satisfies the termination condition for the removal of the hardened layer, and the wafer is controlled to descend to the bearing surface to remove the un-crosslinked layer.

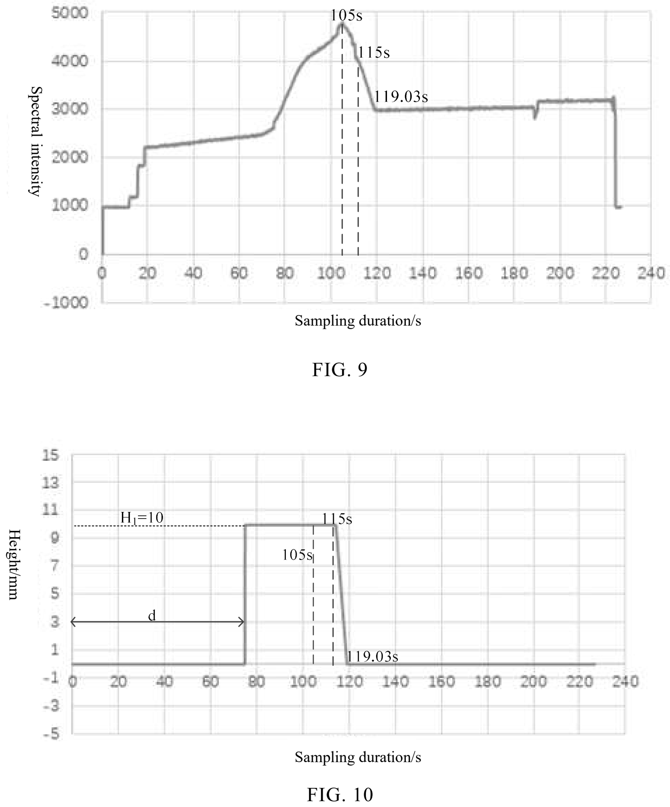

FIG. 9 is a curve relationship diagram of the spectral intensity and sampling duration during the resist removal process using a removal method provided in certain embodiments of the present disclosure, and FIG. 10 is a curve relationship diagram of the height of the wafer relative to the bearing surface and sampling duration during the resist removal process corresponding to FIG. 9. In the examples shown in FIGs. 9 and 10, the resist removal process is as follows: first, the wafer ascends to an initial high position, with the height of the wafer relative to the bearing surface being $H_1$, to remove the hardened layer; the height of the wafer relative to the bearing surface is maintained at $H_1$; when the sampling duration is 105 seconds, the spectral intensity reaches its maximum value. Until the sampling duration reaches 115s, it is determined that the variation characteristic $Q_n$ of the spectral intensity at the current sampling duration is greater than the preset value C, which satisfies the preset conditions, and the wafer is controlled to descend according to the preset relationship to continue cleaning the residual hardened layer; the spectral intensity is continued to be monitored during the descent process until the sampling duration reaches 119.03s, when it is determined that the variation characteristic $Q_n$ of the spectral intensity at the current sampling duration is 0%, which satisfies the termination conditions for hardened layer removal, and the wafer is controlled to descend to the bearing surface to remove the un -crosslinked layer.

In combination with FIGs. 7 to 10, it may be seen that the removal method of certain embodiments controls the wafer to descend to increase the temperature of the wafer when the variation characteristic satisfies the preset conditions and the hardened layer removal process is near the end point but has not reached the end point. The sampling duration corresponding to the end point of the hardened layer removal process is shortened from 129.95s to 119.03s, and the termination time of the hardened layer removal process is advanced by 10.92s. This verifies that the removal method of certain embodiments may effectively shorten the time for removing the hardened layer, thereby greatly improving the resist removal efficiency.

In the removal method disclosed herein, the preset relationship is that the wafer's descent displacement $\Delta h$ is equal to the product of the descent duration $\Delta t$ and a constant a, where a>0. The constant a may be considered the wafer's descent velocity. The descent duration $\Delta t$ is the duration from the start of the descent movement to the current moment. The descent start moment is the sampling moment corresponding to the variation characteristic satisfying the preset conditions.

Taking the preset value as 5%, the preset condition includes that the variation characteristic corresponding to the current sampling moment is greater than 5%. If the sampling duration corresponding to the sampling moment when the variation characteristic is greater than 5% is $t_1$, then when the sampling duration reaches t2, the descent displacement of the wafer $\Delta h = a \times \Delta t = a \times (t_2 - t_1)$. At this point, the height corresponding to the wafer's current position is H' = $H_1$ - $\Delta h$ = $H_1$ - a $\times$ $(t_2 - t_1)$. In certain embodiments, when the variation characteristic corresponding to the current sampling moment satisfies the preset conditions, the wafer is controlled to descend at a uniform speed, causing the wafer to heat up at a uniform rate, thereby reducing the risk of the remaining hardened layer popping during the wafer's descent.

On the basis that the preset condition includes that the variation characteristic corresponding to the current sampling moment is greater than the preset value, the preset condition further includes a delay duration T between the moment when the spectral intensity reaches the maximum value and the current sampling moment. That is to say, after the spectral intensity reaches the maximum value, the height of the wafer is kept unchanged until the interval delay duration T is reached and the variation characteristic is greater than the preset value, and the wafer is controlled to descend according to the preset relationship to remove the hardened layer.

In the removal method disclosed herein, when the spectral intensity reaches a maximum value, the first timer 910 may be used for timing. When the timing time reaches the delay duration T and the variation characteristic is greater than a preset value, the wafer is controlled to descend. Alternatively, in certain embodiments, when the spectral intensity reaches its maximum value, the moment corresponding to the spectral intensity reaching its maximum value may be obtained, and the moment may be added to the delay duration T to obtain the corresponding descent time point. When the descent time point is reached from the current moment and the variation characteristic is greater than the preset value, the wafer is controlled to descend.

Therefore, in the removal method of certain embodiments, the preset conditions are designed, including that the variation characteristic corresponding to the current sampling moment is greater than the preset value, and the interval between the current sampling moment and the moment when the spectral intensity reaches the maximum value is delayed for a length of T, to ensure that the spectral intensity is on the falling edge. When the hardened layer removal process approaches the end point, the wafer is controlled to descend to increase the temperature of the wafer. In this way, while avoiding the popping phenomenon, the hardened layer removal rate may be increased in the later stage of the hardened layer removal process to shorten the hardened layer removal time and thus improve the resist removal efficiency.

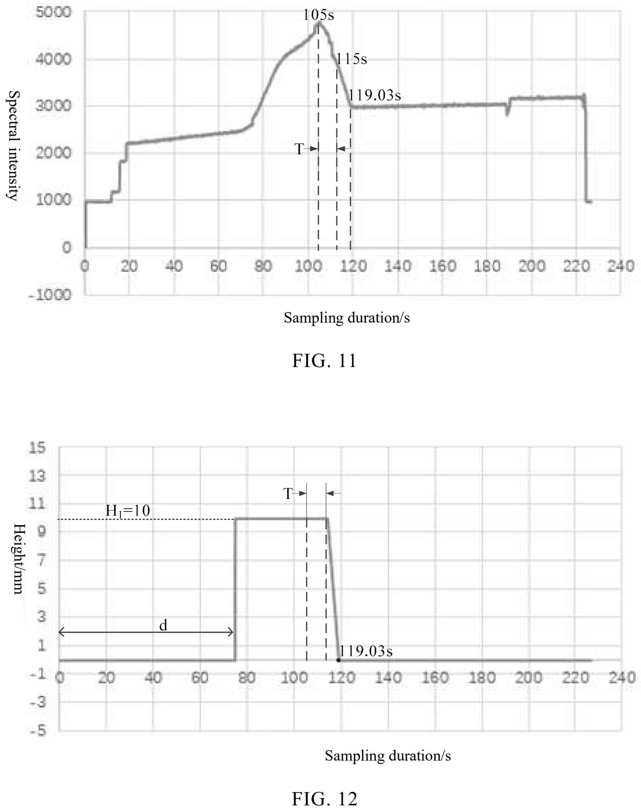

FIG. 11 is a curve relationship diagram of spectral intensity and sampling duration during the resist removal process using another removal method provided in certain embodiments of the present disclosure, and FIG. 12 is a curve relationship diagram of the height of the wafer relative to the bearing surface and sampling duration during the resist removal process corresponding to FIG. 11. In the example shown in FIG. 11 and FIG. 12, the resist removal process is as follows: first, the wafer is raised to an initial high position, with the height of the wafer relative to the bearing surface being $H_1$, to remove the hardened layer; the height of the wafer relative to the bearing surface is maintained at $H_1$; when the sampling duration is 105 seconds, the spectral intensity reaches a maximum value, and the first timer 910 is controlled to start timing. When the sampling duration is 115 seconds, the timing time of the first timer 910 reaches T, and it is determined that the variation characteristic $Q_n$ of the spectral intensity at the current sampling moment is greater than the preset value C, then the preset condition is met, and the wafer is controlled to descend according to the preset relationship to continue cleaning the residual hardened layer. The spectral intensity is continuously monitored during the descent process until the sampling duration reaches 119.03s. The variation characteristic $Q_n$ of the spectral intensity at the current sampling moment is determined to be 0%, which satisfies the termination condition for the removal of the hardened layer. The wafer is controlled to descend to the bearing surface to remove the un-crosslinked layer.

Please refer to FIGs. 7, 8, 11 and 12 together. It may be seen that the removal method of certain embodiments controls the wafer to descend to increase the temperature of the wafer after the spectral intensity reaches the maximum value, after the interval delay duration T and when the variation characteristic $Q_n$ is greater than the preset value. The sampling duration corresponding to the end point of the hardened layer removal process is shortened from 129.95 seconds to 119.03 seconds, and the end time of the hardened layer removal process is advanced by 10.92 seconds. This verifies that the removal method of certain embodiments may effectively increase the hardened layer removal rate, thereby greatly improving the resist removal efficiency.

It should be understood that in an implementation scheme where the preset conditions also include a delay duration T between the moment when the spectral intensity reaches its maximum value and the current sampling moment, if the sampling moment corresponding to the moment when the spectral intensity reaches its maximum value is t', and the interval delay duration is T, and the variation characteristic is greater than the preset value, the sampling duration corresponding to when the wafer starts to decline is t", then the descent duration $\Delta t$ satisfies: $\Delta t = t" - t' - T$. The descent displacement of the wafer is $\Delta h = a \times (t" - t' - T)$. At this time, the height corresponding to the current position of the wafer is $H' = H1 - \Delta h = H1 - a \times (t" - t' - T)$.

The delay duration T may be designed based on past experience and needs. For example, the delay duration T may be 5s, 10s, or the like. Certain embodiments do not impose any specific restrictions on this.

In certain embodiments of the present disclosure, the delay duration T may also be determined by calculation when the spectral intensity reaches its maximum value. Specifically, the delay duration T is calculated according to the following formula (4). Where T is the delay duration; k > 0, and k is a constant; Qmax is the maximum absolute value of the variation characteristic before the spectral intensity reaches its maximum value.

$$T = k/Qmax \qquad\qquad \text{Formula (4)}$$

Among them, the variation characteristic refers to the descent rate of the spectral intensity between two adjacent sampling moments. In the early stage of the hardened layer removal process, the spectral intensity continues to increase, that is, the spectral intensity is on the rising edge, and the variation characteristic $Q_n$ is less than 0. The absolute value of the variation characteristic $Q_n$ represents the ascent rate of the spectral intensity. The maximum value of the absolute value of the variation characteristic $Q_n$ may be understood as the maximum ascent rate of the spectral intensity.

Therefore, it may be understood that the delay duration T is negatively correlated with Qmax, that is, the delay duration T is negatively correlated with the rate of increase of the spectral intensity. Specifically, in the early stage of the hardened layer removal process, the faster the spectral intensity increases, the greater the rate of increase of the spectral intensity, and the larger Qmax, the smaller the delay duration T. On the contrary, in the early stage of the hardened layer removal process, the slower the spectral intensity grows, the smaller the rate of increase of the spectral intensity, and the smaller Qmax, the longer the delay duration T.

In this way, when the method of certain embodiments is used to remove the photoresist, the faster the spectral intensity grows, that is, the greater the rate of the chemical reaction of the hardened layer removal process, the faster the temperature of the wafer is increased after the variation characteristic satisfies the preset conditions, further ensuring that the temperature of the wafer be increased before reaching the end point of the hardened layer removal process.

Moreover, compared with directly setting the delay duration T as a constant, the delay duration T is determined by calculation in certain embodiments, which is conducive to ensuring that for different types of wafers, the delay duration T may be adapted to the rising rate of the spectral intensity during the hardened layer removal process, so as to ensure that the hardened layer removal process has not reached the end point when the time is extended to T from the moment when the spectral intensity reaches the maximum value.

In addition, in an implementation scheme where the preset condition further includes a delay duration T between the time when the spectral intensity reaches the maximum value and the current sampling moment, step S102 may be specifically implemented using the following steps.

S1021, when the spectral intensity reaches a maximum value, determining a variation characteristic of the spectral intensity corresponding to all sampling moments according to the spectral intensity corresponding to two adjacent sampling moments.

S1022: When the absolute value of the variation characteristic of the spectral intensity is greater than the set threshold, execute S103.

The set threshold is set to a positive number and may be reasonably designed based on actual experience and working conditions. In certain embodiments, an additional condition is set for executing step S103, namely, the absolute value of the variation characteristic of the spectral intensity is greater than the set threshold. That is to say, before the spectral intensity reaches its maximum value, in the early stage of the hardened layer removal process, if the rate of increase of the spectral intensity is greater than the set threshold, that is, the spectral intensity increases too fast, then after the spectral intensity reaches its maximum value, at the interval delay duration T, and the variation characteristic Qn is greater than the preset value, the wafer is controlled to descend.

In this way, the method of controlling the wafer to descend after a delay duration T after the spectral intensity reaches a maximum value is suitable for situations where the spectral intensity increases or decreases rapidly.

In any of the above embodiments, preferably, the sampling durations between any two adjacent sampling durations are equal, that is, the spectral intensity of the emitted light generated by a particular element is collected during each sampling duration $\Phi$, $t_n - t_{n-1} = \Phi$, where $\Phi$ is a positive constant. Schematically, $\Phi$ may be set to 0.1s, 0.5s, 1s, or the like. In this way, the spectral intensity may be collected uniformly, especially when the variation characteristic is $S_n'$, which is also conducive to simplifying the calculation of the variation characteristic.

In certain embodiments, before step S101 above, the removal method of certain embodiments may further include the following steps.

S201: Placing the wafer on the bearing surface of the heating base and, after the preheating duration has expired, controlling the wafer to ascend to its initial high position.

Here, the height of the wafer relative to the bearing surface at the initial high position is H1. Referring to FIGs. 9 to 12, $H_1$ may specifically be 10 mm. Of course, $H_1$ is not limited to 10 mm; in other embodiments of the present disclosure, it may also be 12 mm, 15 mm, or the like.

In certain embodiments of the present disclosure, the specific implementation process of step S201 may include the following steps.

Step S2011: At the start of the post-ion implantation photoresist removal process, the wafer is placed on the bearing surface of the heating base and a timer is started.

Specifically, this step may be accomplished by sending a signal to the second timer 920 to initiate timing.

Step S2012: When the timer reaches the preheating duration, the wafer is controlled to ascend from the bearing surface to the initial high position.

The preheating duration d may also be designed based on experience and actual operating conditions. For example, in the examples shown in FIGs. 10 and 12, the preheating duration d may be designed to be 78 seconds.

In certain embodiments, at the beginning of the hardened layer removal process, the wafer is preheated by being placed on the bearing surface of the heating base within the preheating duration d, so that when the wafer moves to the initial high position, it may quickly reach the process temperature of the hardened layer removal process, so that the hardened layer removal process may be carried out as soon as possible, which is beneficial to improving the resist removal efficiency.

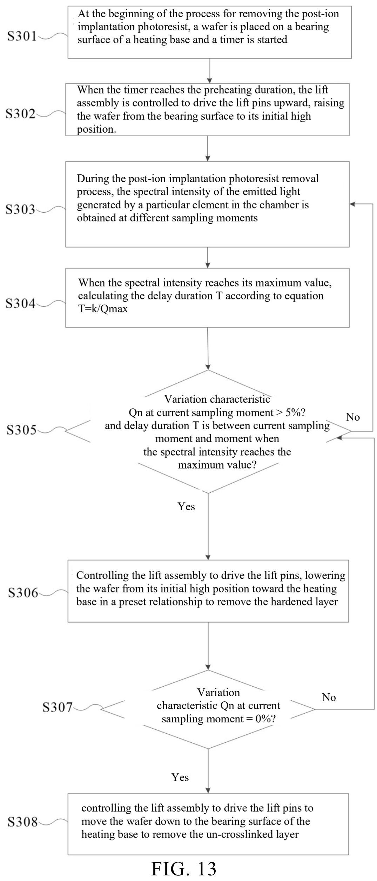

FIG. 13 is a schematic flow chart of another method for removing photoresist from a wafer, provided in certain embodiments of the present disclosure. Referring to FIG. 13, in one specific example, the removal method includes the following steps:

Step S301: At the beginning of the process for removing the post-ion implantation photoresist, a wafer is placed on a bearing surface of a heating base and a timer is started.

Step S302: When the timer reaches the preheating duration d, the lift assembly is controlled to drive the lift pins upward, raising the wafer from the bearing surface to its initial high position.

Step S303: During the post-ion implantation photoresist removal process, the spectral intensity of the emitted light generated by a particular element in the chamber is obtained at different sampling moments.

Step S303: Determining the variation characteristic Qn of the spectral intensity at each sampling moment based on the spectral intensity corresponding to two adjacent sampling moments.

Step S304: When the spectral intensity reaches its maximum value, calculating the delay duration T according to formula (4) above.

Step S305: Determining whether the variation characteristic Qn at the current sampling moment is greater than 5%, and determine whether the delay duration T is between the current sampling moment and the moment when the spectral intensity reaches the maximum value; if so, execute step S306; if not, return to execute step S303.

Step S306: Controlling the lift assembly to drive the lift pins, lowering the wafer from its initial high position toward the heating base in a preset relationship to remove the hardened layer.

Step S307: Determining whether the variation characteristic Qn at the current sampling moment is equal to 0%. If so, the hardened layer removal process is determined to have reached its end point, and step S308 is executed. If not, the process returns to step S305.

Step S308: control the lift assembly to drive the lift pins to move the wafer down to the bearing surface of the heating base to remove the un-crosslinked layer.

It is understood that the above embodiments are merely exemplary embodiments for illustrating the principles of the present disclosure, and the present disclosure is not limited thereto. Those skilled in the technical field may make various modifications and improvements without departing from the spirit and substance of the present disclosure, and such modifications and improvements are also considered to be within the scope of protection of the present disclosure.

## Claims

1.  A method of removing photoresist from a wafer, **characterized in that**:

    during a process of removing photoresist after ion implantation, obtaining a spectral intensity of emitted light generated by a particular element in a chamber at different sampling moments;
    determining a variation characteristic of the spectral intensity at each sampling moment based on spectral intensities at two adjacent sampling moments;
    when the variation characteristic at a current sampling moment satisfies a preset condition, determining that a hardened layer removal process is near an end point and controlling the wafer to descend from its current position toward a heating base according to a preset relationship to remove the hardened layer of the photoresist.

2.  The removal method according to claim 1, **characterized in that** the variation characteristic is a rate of decrease of the spectral intensity between two adjacent sampling moments, and the variation characteristic satisfies the following formula:

$$Q_n = [S(t_{n-1}) - S(t_n)] \div S(t_{n-1});$$

    where Qn is the variation characteristic corresponding to the nth sampling moment, S(tn) is the spectral intensity corresponding to the nth sampling moment, and n is a positive integer.

3.  The removal method according to claim 2, **characterized in that** the preset condition includes that the variation characteristic corresponding to the current sampling moment is greater than a preset value, and the preset value is a non-negative number.

4.  The removal method according to claim 3, **characterized in that** the preset value is greater than or equal to 5% and less than or equal to 20%.

5. The removal method according to claim 3, **characterized in that** the preset condition further includes a delay duration between the time when the spectral intensity reaches the maximum value and the current sampling moment.

6. The removal method according to claim 5, **characterized in that** the delay duration is calculated according to the following formula:

$$\Gamma = k/Q_{max};$$

wherein, T is the delay duration; $k > 0$, and k is a constant; Qmax is the maximum value of the absolute value of the variation characteristic before the spectral intensity reaches the maximum value.

7. The removal method according to any one of claims 1 to 6, **characterized in that** the preset relationship is that the descent displacement $\Delta h$ of the wafer is equal to the product of the descent duration $\Delta t$ and a constant a, and a is greater than 0.

8. The removal method according to any one of claims 1 to 6, **characterized in that**, before obtaining the spectral intensity of the emitted light generated by the particular element in the chamber at different sampling moments, the removal method further comprises:
   placing the wafer on the bearing surface of the heating base, and after the preheating duration has expired, controlling the wafer to ascend to an initial high position.

9. The removal method according to any one of claims 1 to 6, **characterized in that**, after controlling the wafer to descend from its current position toward the heating base according to a preset relationship to remove the hardened layer of the photoresist, the method further comprises:
   controlling the wafer to descend to the bearing surface of the heating base to remove the un-crosslinked layer of the photoresist when the variation characteristic corresponding to the current sampling moment satisfies a hardened layer removal termination condition.

10. A semiconductor process device, **characterized in that**, comprising:

    a chamber;
    a heating base, arranged within the chamber and having a bearing surface for supporting a wafer;
    a controller, including at least one processor and at least one memory, the memory storing a computer program, the processor executing the computer program to perform the removal method according to any one of claims 1 to 9.

FIG. 1

Wafer's temperature

Distance of wafer to bearing surface

FIG. 2

FIG. 3

FIG. 4

during the process of removing the photoresist after ion implantation, obtaining the spectral intensity of the emitted light generated by a particular element in the chamber at different sampling moments — S101

determining a variation characteristic of the spectral intensity at each sampling moment according to the spectral intensities corresponding to two adjacent sampling moments — S102

when the variation characteristic corresponding to the current sampling moment satisfies the preset conditions, determining that the hardened layer removal process is near the end point and the wafer is controlled to descend from the current position toward the heating base according to the preset relationship to remove the hardened layer of the photoresist — S103

FIG. 5

Resist removal speed rate

Wafer's temperature

FIG. 6

FIG. 7

FIG. 8

FIG. 9

FIG. 10

FIG. 11

FIG. 12

S301 — At the beginning of the process for removing the post-ion implantation photoresist, a wafer is placed on a bearing surface of a heating base and a timer is started

S302 — When the timer reaches the preheating duration, the lift assembly is controlled to drive the lift pins upward, raising the wafer from the bearing surface to its initial high position.

S303 — During the post-ion implantation photoresist removal process, the spectral intensity of the emitted light generated by a particular element in the chamber is obtained at different sampling moments

S304 — When the spectral intensity reaches its maximum value, calculating the delay duration T according to equation T=k/Qmax

S305 — Variation characteristic Qn at current sampling moment > 5%? and delay duration T is between current sampling moment and moment when the spectral intensity reaches the maximum value?

No

Yes

S306 — Controlling the lift assembly to drive the lift pins, lowering the wafer from its initial high position toward the heating base in a preset relationship to remove the hardened layer

S307 — Variation characteristic Qn at current sampling moment = 0%?

No

Yes

S308 — controlling the lift assembly to drive the lift pins to move the wafer down to the bearing surface of the heating base to remove the un-crosslinked layer

FIG. 13

## INTERNATIONAL SEARCH REPORT

| International application No. |
| --- |
| **PCT/CN2024/113270** |

| A. | CLASSIFICATION OF SUBJECT MATTER |
| --- | --- |

G03F 7/42(2006.01)i

According to International Patent Classification (IPC) or to both national classification and IPC

| B. | FIELDS SEARCHED |
| --- | --- |

Minimum documentation searched (classification system followed by classification symbols)

IPC:G03F

Documentation searched other than minimum documentation to the extent that such documents are included in the fields searched

Electronic data base consulted during the international search (name of data base and, where practicable, search terms used)

CNTXT, ENTXT, ENTXTC: 华创微电子, 芯恩, 李孟, 孔宇威, 林源为, 光刻胶, 光阻, 抗蚀剂, 去除, 除去, 硬壳, 硬化, 离子注入, 干法, 成分, 元素, 含量, 光谱, 强度, 即将, 将要, 接近, 邻近, 升温, 温度, 下降, 升降, 间隔, 时长, 爆裂, photoresist, remove, hard shell, harden+, ion implant, composition, element, content, spectrum, intensity, close to, adjacent to, temperature, decrease, interval, duration, popping

| C. | DOCUMENTS CONSIDERED TO BE RELEVANT | |
| --- | --- | --- |

| Category* | Citation of document, with indication, where appropriate, of the relevant passages | Relevant to claim No. |
| --- | --- | --- |
| Y | US 6199561 B1 (OKI ELECTRIC INDUSTRY CO., LTD.) 13 March 2001 (2001-03-13) claims 1 and 3, description, columns 2, 4, and 5, and figure 2 | 1-8, 10 |
| Y | CN 111650821 A (SHANGHAI JET-PLASMA TECHNOLOGY CO., LTD.) 11 September 2020 (2020-09-11) claim 1, and description, paragraph [0017] | 1-8, 10 |
| A | CN 101151715 A (PANASONIC CORP.) 26 March 2008 (2008-03-26) entire document | 1-10 |
| A | CN 103578971 A (SHANGHAI HUALI MICROELECTRONICS CORP.) 12 February 2014 (2014-02-12) entire document | 1-10 |
| A | JP 2001274139 A (NEC CORP.) 05 October 2001 (2001-10-05) entire document | 1-10 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **20 November 2024** | **25 November 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/113270**

| Patent document cited in search report | | | Publication date (day/month/year) | Patent family member(s) | | | Publication date (day/month/year) |
|---|---|---|---|---|---|---|---|
| US | 6199561 | B1 | 13 March 2001 | US | 2001000409 | A1 | 26 April 2001 |
| | | | | US | 6323454 | B2 | 27 November 2001 |
| | | | | JPH | 1167738 | A | 09 March 1999 |
| CN | 111650821 | A | 11 September 2020 | | None | | |
| CN | 101151715 | A | 26 March 2008 | US | 2009104783 | A1 | 23 April 2009 |
| | | | | KR | 20080005190 | A | 10 January 2008 |
| | | | | JPWO | 2006106871 | A1 | 11 September 2008 |
| | | | | EP | 1865547 | A1 | 12 December 2007 |
| | | | | WO | 2006106871 | A1 | 12 October 2006 |
| CN | 103578971 | A | 12 February 2014 | | None | | |
| JP | 2001274139 | A | 05 October 2001 | | None | | |

Form PCT/ISA/210 (patent family annex) (July 2022)